(19) Europäisches Patentamt
European Patent Office
Office européen des brevets

(11) **EP 4 686 103 A1**

(12) **EUROPEAN PATENT APPLICATION**

(43) Date of publication:
**28.01.2026 Bulletin 2026/05**

(21) Application number: **25190473.6**

(22) Date of filing: **18.07.2025**

(51) International Patent Classification (IPC):
***H03L 7/081*** (2006.01)     ***H03L 7/091*** (2006.01)

(52) Cooperative Patent Classification (CPC):
**H03L 7/0814; H03L 7/091;** H03L 2207/50

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **26.07.2024 US 202463675918 P**

(71) Applicant: **Marvell Asia Pte Ltd Singapore 369522 (SG)**

(72) Inventors:
• **Guo, Jianmin**
  **Fremont, CA, 94539 (US)**
• **Ma, Xin**
  **San Jose, CA, 95130 (US)**
• **Deng, Jingjing**
  **San Jose, CA, 95134 (US)**
• **Wang, Hui**
  **Pleasanton, CA, 94588 (US)**

(74) Representative: **Grünecker Patent- und Rechtsanwälte PartG mbB Leopoldstraße 4 80802 München (DE)**

(54) **ALL-DIGITAL PHASE LOCKED LOOP PHASE TRACKING TECHNIQUES**

(57)    An ADPLL circuit includes a phase comparator for comparing a phase of a reference clock (REFCLK) input signal with a phase of a digitally controlled oscillator clock (DCO_CLK) signal output from a DCO. The phase comparator includes a first ADC connected to receive a REF_P signal corresponding to the phase of the REFCLK signal via a first switch and output an ADC0 signal and a second ADC connected to receive the signal REF_P via a second switch and output an ADC1 signal. The ADPLL circuit further includes a digital filter for receiving the ADC0 and ADC1 signals and determining therefrom a difference between the phases of the DCO_CLK signal and the REFCLK signal. The digital filter provides a DCO control signal to the DCO to control a frequency of operation of the DCO based on the phase difference.

FIG. 5

EP 4 686 103 A1

## Description

Priority Application

This patent application claims priority to and/or the benefit of U.S. Provisional Application No. 63/675,918, entitled, "ADPLL (All Digital Phase Locked Loop) Phase Tracking Method," filed on July 26, 2024, which U.S. Provisional Application is hereby incorporated by reference in its entirety.

Background

A phase-locked loop (PLL) is a control system that generates an output signal the phase of which is fixed relative to the phase of an input, or reference, signal. A PLL typically includes a voltage-controlled oscillator (VCO) and a phase detector (or phase comparator) such that the output frequency of the PLL is continuously adjusted according to the frequency of its input signal. PLLs are widely used in a variety of applications, including but not limited to clock recovery, demodulation in communications systems, and frequency synthesis. PLLs assist in maintaining a constant phase angle relative to a reference signal, making them invaluable in high-frequency electronics.

Integral non-linearity (INL) and differential non-linearity (DNL) are performance metrics that indicate how accurately the output of a converter represents the input thereto. INL measures the deviation of the actual transfer function from a straight line, while DNL measures the deviation of the step size between adjacent output codes from the ideal one least significant bit (LSB) value. An all-digital PLL (ADPLL) may employ a time-to-digital converter, or time digitizer (TDC), as a phase detector for reading a phase difference between the VCO signal and the reference signal; however, conventional TDCs are low performing at integral non-linearity (INL) and differential non-linearity (DNL), rendering them less than ideal for implementation in an ADPLL.

Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.

FIG. 1 illustrates an exemplary computing system, according to some embodiments of the disclosure.
FIG. 2 illustrates a block diagram of an exemplary PLL, according to some embodiments of the disclosure.
FIG. 3 illustrates a block diagram of an exemplary digital PLL (DPLL), according to some embodiments of the disclosure.
FIG. 4 illustrates a block diagram of an alternative embodiments of an exemplary DPLL, according to some embodiments of the disclosure.
FIG. 5 illustrates a block diagram of an exemplary ADPLL, according to some embodiments of the disclosure.
FIG. 6 illustrates a block diagram of an exemplary digital filter employed in the ADPLL of FIG. 5, according to some embodiments of the disclosure.
FIGs. 7-9 respectively illustrate a waveform representing the phase of a REFCLK signal, according to some embodiments of the disclosure.
FIG. 10 illustrates a flow diagram of exemplary operations that may be performed by the ADPLL of FIG. 5, according to some embodiments of the disclosure.

Detailed Description

*Overview*

As previously noted, certain implementations of an ADPLL may employ a TDC for performing phase detection, resulting in poor performance with respect to INL and DNL, as well as noise (Rj) and power consumption. According to features of embodiments described herein, phase detection is performed using a pair of analog-to-digital converters (ADCs) to sample the phase difference between an output signal and a reference signal in an ADPLL. ADCs perform much better with regard to INL, DNL, Rj, and power consumption, providing an advantage over ADPLLs that employ TDCs to perform phase detection.

*Exemplary computing system*

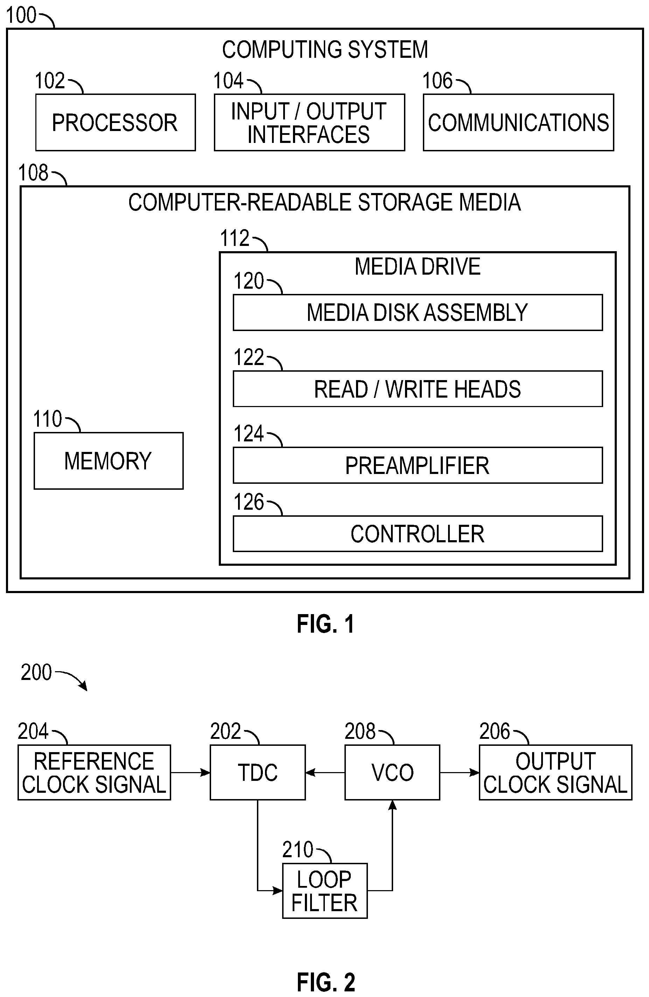

FIG. 1 illustrates computing system 100, according to some embodiments of the disclosure. Examples of computing system 100 can include: laptop computers, desktop computers, mobile computing devices, data servers.

Computing system 100 may include processor 102. Processor 102 may manage data processing tasks. Processor 102 can include one or more suitable types of processors, and one or more suitable number of processors. Processor 102 may be a single-core processor, or a multi-core (e.g., ARM or x86 processor cores). Examples of processor 102 may include a central processing unit (CPU), a graphics processing unit (GPU), a field-programmable gate array (FPGA), a tensor processing unit (TPU), a data processing unit (DPU), a digital signal processor (DSP), an application specific integrated circuit (ASIC), etc. Processor 102 can execute instructions or commands of an operating system. Processor 102 can perform operations and/or computations for an application of computing system 100.

Computing system 100 may include input/output interfaces 104. Input/output interfaces 104 may include one or more interfaces to facilitate communication between processor 102 and one or more external devices. Input/output interfaces 104 can include ports for connecting peripherals, such as Universal Serial Bus (USB), audio inputs/outputs, displays, and human interface devices.

Computing system 100 may include communications 106. Communications 106 may handle data network connectivity, including wired interfaces like Ethernet or fiber optic interfaces, and wireless interfaces for communication over wireless networks such as Wireless Local Area Networks (WLANs), cellular networks, and Wireless Personal Area Networks (WPANs). Examples of communications 106 include a Gigabit Ethernet port for fast wired network connections and a Wi-Fi module supporting 802.11ac for high-speed wireless internet access.

Computing system 100 may include computer-readable storage media 108. Computer-readable storage media 108 may include memory 110. Computer-readable storage media 108 may include media drive 112. Computer-readable storage media 108 may store instructions, when executed by processor 102, that cause processor 102 to perform one or more operations.

Memory 110 can include volatile memory. Memory 110 can include non-volatile memory. Volatile memory may include various types of random-access memory (RAM), e.g., Dynamic Random-Access Memory (DRAM) and Static Random-Access Memory (SRAM). Non-volatile memory may include Read-Only Memory (ROM), Electrically Erasable Programmable Read-Only Memory (EEPROM), and Flash memory. These memories can data associated with the application and/or the operating system executing on processor 102.

An example of media drive 112 is an HDD, which is a type of non-volatile storage device used in computing system 100 to physically store and retrieve data. Media drive 112 may include media disk assembly 120. Media disk assembly 120 may include the physical disks or platters where data is stored magnetically. Platters are circular disks coated with magnetic material where data is stored. Platters can be made of aluminum or glass and are coated with a thin layer of magnetic material. The platters are mounted on a spindle, which is rotated by a motor. The platters can be mounted on an integrated spindle and motor assembly, which rotates the disks under read/write heads 122. Media disk assembly 120 can include multiple platters, each storing data on both sides. The speed at which the platters spin is measured in revolutions per minute (RPM), with common speeds being 5400 RPM, 7200 RPM, and higher for performance drives.

Media drive 112 may include read/write heads 122. Read/write heads 122 read data from and write data to the disks. Read/write heads 122 are positioned by an actuator, floating just above the surface of the platters, to access different areas of the disk surface. The actuator may have an arm that moves the read/write heads across the platters to access different tracks and sectors. The movement is controlled by a voice coil motor, which allows precise positioning. Read/write heads 122 may include dedicated read and write elements (e.g., referred to herein as readers or writers). For instance, read/write heads 122 may include a Giant Magnetoresistive (GMR) read head that detects magnetic changes on the disk surface with high sensitivity. Read/write heads 122 may include a write head that generates magnetic fields and alters the magnetic fields on the disk surface to write data.

Media drive 112 may include preamplifier 124. Preamplifier 124 may include a preamplifier for a writer to amplify the signals to the write heads before they are used by the write heads. The preamplifier for the writer ensures that the signals are strong enough for accurate data writes. Preamplifier 124 may include a preamplifier for a reader to amplify the signals acquired by the read heads before they are processed. The preamplifier for the reader ensures that the signals are strong enough for accurate data reads/interpretation. The preamplifier for the reader can boost weak signals from the read head to a level suitable for digital processing, ensuring reliable data readback.

Media drive 112 may include controller 126. Controller 126 can manage the overall operation of media drive 112, including the movement and positioning of read/write heads 122, the processing of data signals, data encoding/decoding, and communication with the computer system. Controller 126 can include a storage media controller, servo control unit, and read/write channel. The storage media controller enables processor 102 to access contents of media disk assembly 120, such as an operating system, applications, or data for applications or other services. The storage media controller can write and read data to and from media disk assembly 120. For example, the storage media controller may manage data caching to improve read/write performance. The servo control unit can ensure precise positioning of read/write heads 122 to access specific data sectors on media disk assembly 120 and manages the encoding and decoding of data signals. The servo control unit controls mechanical operations, such as positioning of read/write heads 122 and rotational speed control through the spindle and motor assembly of media disk assembly 120. For instance, it ensures read/write heads 122 are accurately positioned over the correct track on the disk. The read/write channel includes digital-to-analog and analog-to-digital paths for converting write data to write signals or converting read signals to read data. The read/write channel processes and encodes signals when data is written to media disk assembly 120 and decodes signals when data is read from media disk assembly 120. For example, the read/write channel handles signal conditioning, sampling, equalization, phase adjustment, detection, and error correction to ensure reliable data storage and retrieval.

*Fundamentals of PLLs, including digital PLLs (DPLLs)*

FIG. 2 illustrates a PLL 200, which, as previously noted, is a control system that uses a feedback loop to synchronize, or lock, the phase of an output signal with that of a reference signal. When the signal phases are locked, the output frequency is typically a multiple of the reference frequency. PLL 200 may be included as a component of a variety of electronic devices, such as computing system 100 (FIG. 1) and/or components thereof.

As shown in FIG. 2, PLL 200 includes a phase detector 202 which compares the phase of an input reference signal, or reference clock signal, 204 with an output signal 206 from a VCO 208. A loop filter 210 is provided for smoothing the output of phase detector 202, removing unwanted high-frequency components and providing a DC voltage proportional to the phase difference. The frequency of VCO 208 is controlled by the DC voltage from loop filter 210. As the frequency of VCO 208 changes, the phase of output signal changes 206, eventually aligning with that of reference signal 204. In some applications, a frequency divider (not shown in FIG. 2) 212 may be provided to reduce the frequency of output signal 206 before it is compared to reference signal 204 by the phase detector 202.

In operation, phase detector 202 compares the phase of input reference signal 204 and output signal 206. Loop filter 210 smooths the output of phase detector 202, creating a DC voltage provided to VCO 208. The frequency of VCO is adjusted based on the DC voltage from loop filter 210. This process is repeated until the phase difference between input reference signal 204 and output signal 206 is minimized or essentially eliminated, at which point the loop is deemed locked.

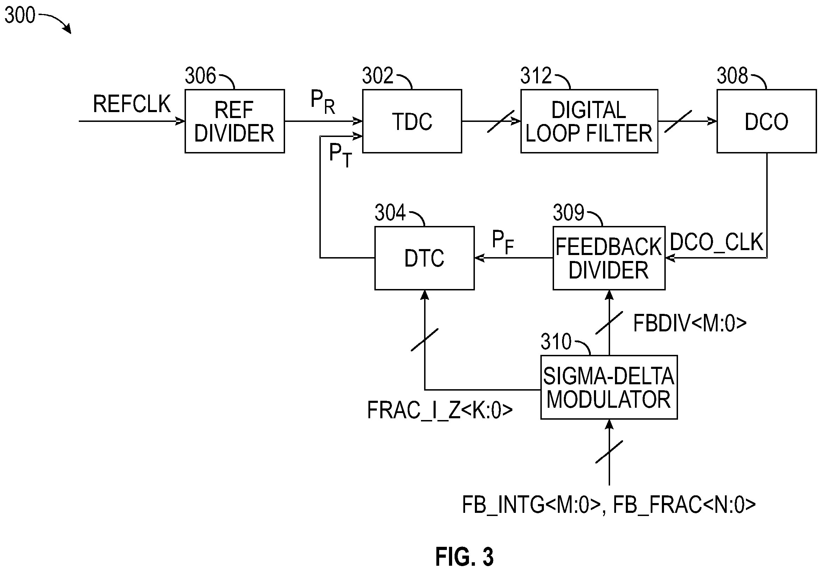

FIG. 3 is a block diagram of an exemplary DPLL 300, in which a phase detection function is performed using a combination of a time-to-digital converter (TDC) 302, which measures the time difference between two signals input thereto and outputs a signal indicative of the difference, and a digital-to-time converter (DTC) 304, which converts a digital code into a time delay and shifts the phase of a signal input thereto in accordance with the time delay indicated by the digital code, thereby enabling precise frequency synthesis and phase control. In particular, as shown in FIG. 3, an input reference signal REFCLK is divided by a reference divider function 306 and the phase of the reference signal, designated $P_R$, is input to TDC 304 to be compared with the time-shifted phase $P_T$ of the output signal of a digitally controlled oscillator (DCO) 308, which is a frequency generator that generates an output clock DCO_CLK based on a control signal input thereto.

In operation, the signal output from DCO 308 (DCO_CLK), is input to a feedback divider 309, which processes the signal in accordance with a control signal FBDIV<M:0> from a sigma-delta modulator 310 controlled by control signals FB_INTG<M:0> (which is a feedback integer portion), FB_FRAC<N:0> (which is a feedback fractional portion), to generate a feedback signal having a phase $P_F$. In particular, feedback divider 209 divides DCO_CLK to allow for finer frequency control and fractional-N synthesis.

DTC 304 shifts the phase of the feedback signal from $P_F$ to $P_T$ by an amount indicated by control signal FRAC_I Z<k:0> generated by the sigma-delta modulator 310, which represents the fractional part of the phase position. The time shifted phase $P_T$ is input to TDC 302 to be compared with the phase of the input reference signal $P_R$ and a signal indicative of the difference between phases $P_T$ and $P_R$ is output to a digital loop filter 312, which processes the output of TDC 302 to smooth out the phase error signal and provide a stable control signal to DCO 308.

While inclusion of DTC 304 in DPLL 300 reduces the phase gap between $P_T$ and $P_R$, which eases the linearity design of TDC 302; the linearity design of DCC 304 itself is complex and difficult, thereby complicating the overall circuit design.

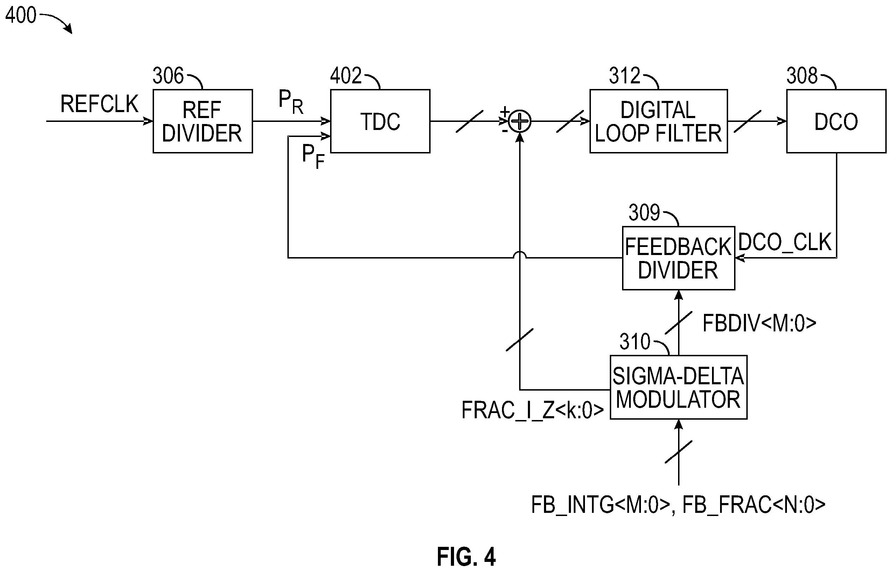

FIG. 4 is a block diagram of an exemplary DPLL 400, which is similar in most respects to DPLL 300 except that the phase detection function is performed using a TDC 402 alone and without the use of a DTC (such as DTC 304). In the DPLL 400, the mathematical operation of the output of TDC 402 with the FRAC_I_Z<k:0> control signal is performed in the digital domain at accumulator 404, the output of which is input to digital loop filter 312.

While omission of a DTC in DPLL 400 reduces the overall circuitry less complex than that of DPLL 300, the linearity design of TDC 402 must be close to ideal.

*Exemplary ADPLL using analog-to-digital (ADC) converters for phase comparison*

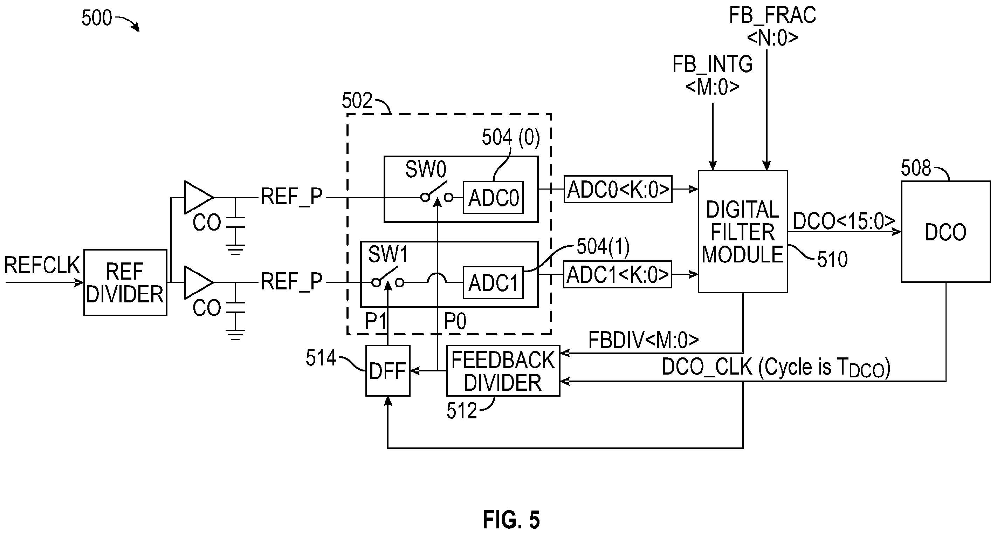

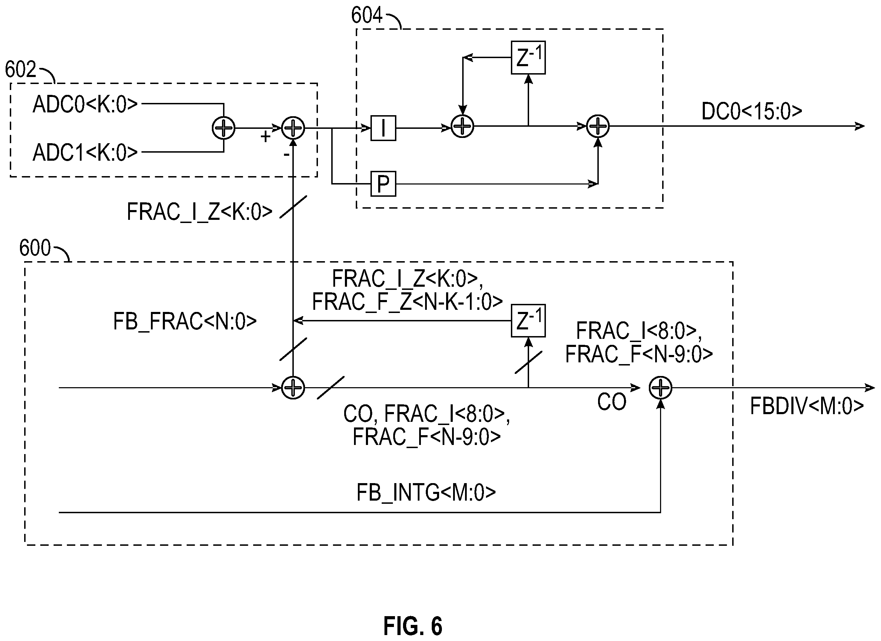

FIG. 5 illustrates an ADPLL 500 according to embodiments described herein. In particular, ADPLL 500 may be described as a sigma-delta fractional-N ADPLL. As shown in FIG. 5, ADPLL 500 includes a TDC phase detector 502 implemented using a pair of ADCs 504(0) and 504(1) to compare the phase REF_P of an input reference signal (REFCLK) with the phase of DCO_CLK output from a DCO 508. In particular embodiments, the period of DCO_CLK is $T_{DCO}$. A digital filter module 510 (which is described in greater detail below with reference to FIG. 6) is provided for processing signals ADC0<K:0> and ADC1<K:0> respectively output from ADC504(0) and ADC504(1) in accordance with control signals FB_INTG<M:0> and FB_FRAC<N:0> as will be described in greater detail below and for providing a digital control signal DCO<15:0> to DCO 508 for controlling the frequency thereof in a conventional manner. As the frequency of DCO 508 changes under the control of DCO<15:0>, the phase of output signal DCO_CLK changes, eventually aligning with that of REF_CLK. Control signals FB_INTG<M:0> and FB_FRAC<N:0> collectively identify a feedback code (FB_CODE) comprising a fractional number configured to ensure the proper frequency of DCO_CLK according to the following equation:

$$F_O = F_{REF}/REFDIV * FB\_CODE$$

where $F_O$ is the frequency of DCO_CLK and $F_{REF}$ is the frequency of REFCLK.

As illustrated in FIG. 5, a feedback divider 512 receives DCO_CLK from DCO 508 and control signal FBDIV<M:0> from digital filter module 510, which identifies an amount by which to divide the frequency of DCO_CLK, and outputs a signal P0 representative of the phase of DCO_CLK, which signal P0 controls operation of switch SW0. Signal P0 is further input to a delay flip flop (DFF) 514, which is clocked by DCO_CLK to generate a phase signal P1, which is delayed from signal P0 by an amount of time equal to the period of the DCO_CLK signal; i.e., 1 $T_{DCO}$. Signal P1 controls operation of switch SW1. In particular embodiments, feedback divider 512 is implemented as an integer feedback divider.

A signal representing the phase of the reference clock (REF_P) is provided to ADC0 and ADC1 through switches SW0 and SW1, respectively. ADC0 and ADC1 respectively output codes ADC0<K:0> and ADC1<K:0>, which correspond to sample points on a curve representing REF_P, as will be illustrated hereinbelow. As will also be described, ADC0<K:0> and ADC1<K:0> are processed by digital filter module 510, which identifies from the codes a phase difference between the phase of DCO_CLK and that of REFCLK and generates a control signal DCO<15:0> to control the frequency of DCO 508 in accordance with the phase difference.

FIG. 6 is a block diagram of digital filter module 510 showing additional details thereof. In a particular embodiment, digital filter module 510 includes a sigma-delta modulator 600 for interpolating between integer multiples of a reference frequency to achieve fractional frequency synthesis, a circuit 602 for mathematically comparing the output of the phase comparator 502 (FIG. 5), i.e., ADC0<K:0> and ADC1<K:0>, with a fractional number of output of sigma-delta modulator 600 (i.e., FRAC_I_Z<K:0>), and a digital loop filter 604 comprising a proportional-integral-derivative (PID) control loop (described below) for processing the output of circuit 602 to smooth out the phase error signal and provide a stable control signal to DCO 508 (FIG. 5). Sigma-delta modulator 600 also generates the signal FBDIV<M:0> in which is encoded an integer number for controlling operation of feedback divider 512.

A PID control loop is a common feedback control loop that automatically adjusts a process variable to reach a desired setpoint by continuously comparing the current value of the process variable to a setpoint, calculating an error, and then using this error to adjust the output of the controller.

A proportional (P) portion of the PID loop responds to the current error; if the error is large, a larger adjustment will be made to the output. As the error size decreases, the proportional adjustment will also decrease. An integral (I) portion of the PID loop responds to the accumulated error over time. It helps to eliminate steady-state errors that persist even when the system is supposed to be stable. Finally, a derivative (D) portion of the PID loop responds to the rate of change of the error, helping to eliminate undesirable errors such as oscillations and overshoot.

In general, a PID control loop uses a combination of the proportional, integral, and derivative portions to calculate an error (e.g., the phase gap between REF_P and the phase of DCO_CLK), adjust the output (e.g., the value of DCO<15:0>), including determining by how much and how quickly to do so, and monitor and adjust until the process variable (e.g., the phase of DCO_CLK reaches and stays at the desired setpoint (e.g., REF_P).

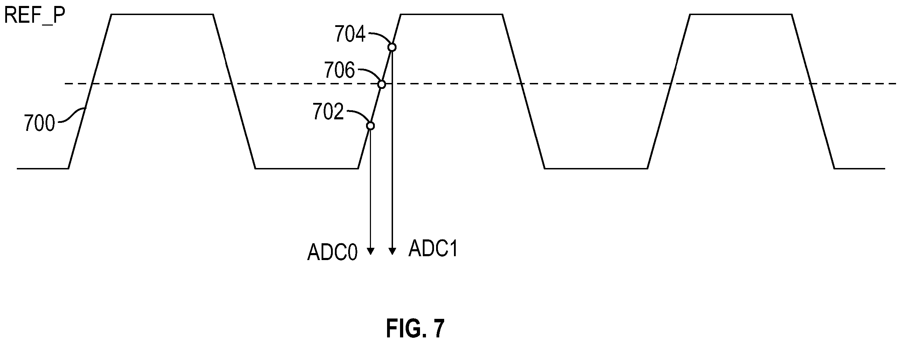

FIG. 7 illustrates a waveform 700 representing the phase of the REF_CLOCK signal (REF_P). As shown in FIG. 7, a first point 702 on waveform 700 is identified by ADC0<K:0> output from ADC0, while a second point 704 on waveform 700 is identified by ADC1<K:0> output from ADC1. In accordance with features of embodiments described herein, when the phases of REF_CLK and DCO_CLK are locked, the sum of ADC0<K:0> and ADC1<K:0> will be equal to FRAC_I_Z<k:0>, represented by a point 706 on waveform 700. It will be recognized that while in the embodiments illustrated in FIGs. 7-9, FRAC_I_Z<k:0> is equal to zero, in various situations, FRAC_I Z<k:0> may be a non-zero number. In the example illustrated in FIG. 7, the phases are locked, as the sum of ADC0<K:0> and ADC1<K:0> is equal to FRAC_I_Z<k:0>.

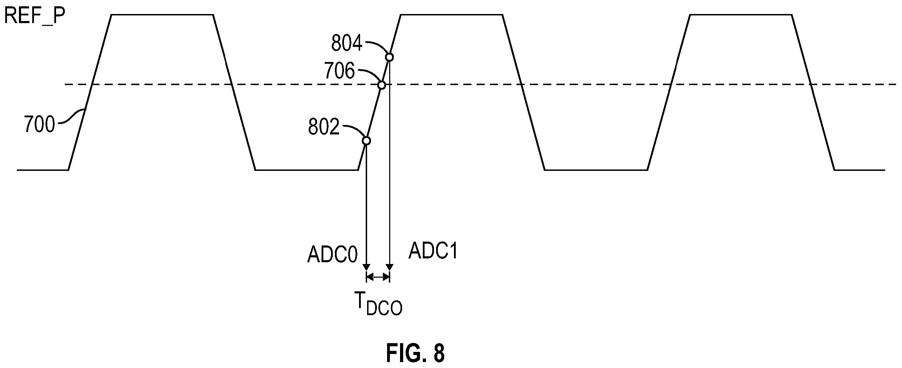

FIG. 8 illustrates an example in which the phase of DCO_CLK lags behind that of REFCLK. In the example shown in FIG. 8, and similar to the example illustrated in FIG. 7, a first point 802 on waveform 700 is identified by ADC0<K:0> output from ADC0 and a second point 804 on waveform 700 is identified by ADC1<K:0> output from ADC1. Unlike the example illustrated in FIG. 7, in the example illustrated in FIG. 8, the sum of ADC0<K:0> and ADC1<K:0> is less than FRAC_I_Z<k:0>, again represented by point 706 on waveform 700, corresponding to a situation in which the phase of DCO_CLK lags behind that of REFCLK. Moreover, the difference between the sum of ADC0<K:0> and ADC1<K:0> and FRAC_I_Z<k:0> is indicative of the amount by which the phase of DCO_CLK lags behind that of REFCLK.

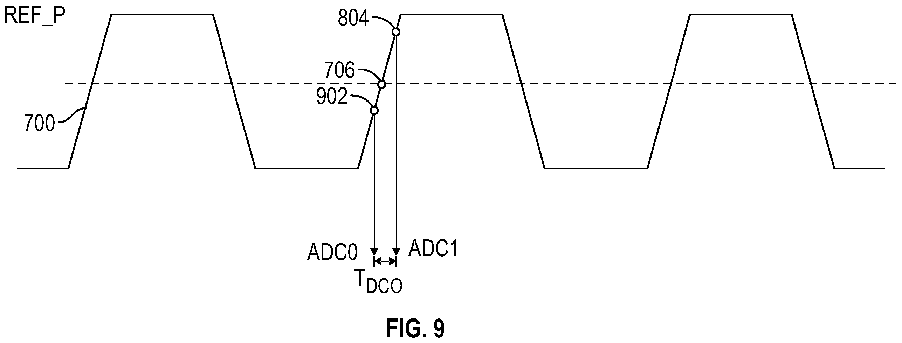

FIG. 9 illustrates an example in which the phase of DCO_CLK leads that of REFCLK. In the example shown in FIG. 9, and similar to the example illustrated in FIG. 7, a first point 902 on waveform 700 is identified by ADC0<K:0> output from ADC0 and a second point 904 on waveform 700 is identified by ADC1<K:0> output from ADC1. Unlike the example illustrated in FIG. 7, in the example illustrated in FIG. 9, the sum of ADC0<K:0> and ADC1<K:0> is greater than FRAC_I_Z<k:0>, again represented by point 706 on waveform 700, corresponding to a situation in which the phase of DCO_CLK leads that of REFCLK. Moreover, the difference between the sum of ADC0<K:0> and ADC1<K:0> and FRAC_I_Z<k:0> is indicative of the amount by which the phase of DCO_CLK leads that of REFCLK.

*Exemplary methods for using ADCs for phase comparison in an ADPLL*

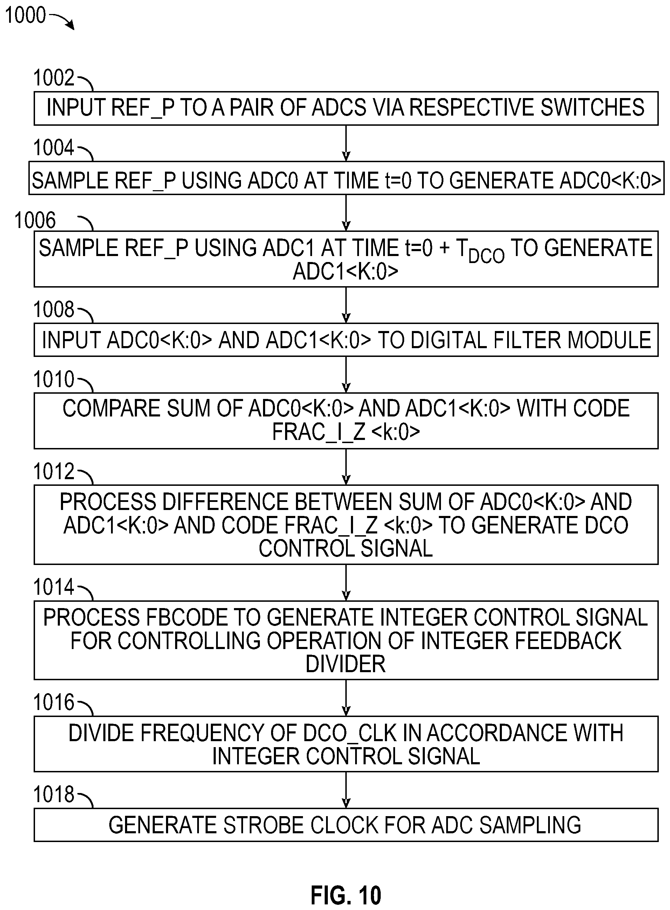

FIG. 10 depicts a flow chart illustrating a method 1000 for using a pair of ADCs to perform phase comparison in an ADPLL, according to some embodiments of the disclosure. Method 1000 may be performed by components illustrated in FIG. 5-6.

At 1002, a signal REF_P representing the phase of a reference clock signal REFCLK may be input to a pair of ADCs (ADC0 and ADC1) via respective switches (SW0 and SW1). In accordance with features of embodiments described herein, operation of switches SW0 and SW1 are controlled by signals P0 and P1 which are representative of the phase of an output signal of a DCO (e.g., DCO_CLK) separated by a period $T_{DCO}$, which is the period of DCO_CLK.

At 1004, at a time t=0, REF_P is sampled by the first ADC (ADC0) to generate a code ADC0<K:0>.

At 1006, at a time t=0 + $T_{DCO}$, REF_P is sampled by the second ADC (ADC1) to generate a code ADC1<K:0>.

At 1008, ADC0<K:0> and ADC1<K:0> are input to a digital filter.

At 1010, the sum of ADC0<K:0> and ADC1<K:0> is compared to a code FRAC_I_Z<k:0> generated from a feedback code FBCODE.

At 1012, the difference between the sum of ADC0<K:0> and ADC1<K:0> and code FRAC_I_Z<k:0> is processed to generate a control signal DCO<15:0> for controlling a frequency of a DCO.

At 1014, FBCODE is processed to generate an integer control signal FBDIV<M:0> for controlling operation of an integer feedback divider.

At 1016, integer feedback divider divides the frequency of DCO_CLK in accordance with FBDIV<M:0>.

At 1018, integer feedback divider generates strobe clock P0 and P1 to switches SW0 and SW1 for ADC sampling.

Although the operations of the example method shown in and described with reference to FIG. 10 are illustrated as occurring once each and in a particular order, it will be recognized that the operations may be performed in any suitable order and repeated as desired. Additionally, one or more operations may be performed in parallel. Furthermore, the operations illustrated in FIG. 10 may be combined or may include more or fewer details than described.

*Select examples*

Example 1 provides an all-digital phase locked loop (ADPLL) circuit, including a phase comparator for comparing a phase of a reference clock (REFCLK) signal input to the ADPLL circuit with a phase of an output clock (DCO_CLK) signal output from a digitally controlled oscillator (DCO), the phase comparator including a first analog-to-digital converter (ADC) connected to receive a REF_P signal corresponding to the phase of the REFCLK signal via a first switch and output an ADC0 signal; and a second ADC connected to receive the signal REF_P via a second switch and output an ADC1 signal; a digital filter for receiving the ADC0 and ADC1 signals and determining therefrom a difference between the phase of the DCO_CLK signal and the phase of the REFCLK signal, the digital filter configured to provide a DCO control signal to the DCO to control a frequency of operation of the DCO based on the phase difference.

Example 2 provides the ADPLL circuit of example 1, further including a feedback divider configured to receive the DCO_CLK signal from the DCO, perform frequency division on the received DCO_CLK signal based on a feedback divider control signal, and output a signal $P_0$ indicative of the phase of the divided DCO_CLK signal, in which the signal $P_0$ controls operation of the first switch.

Example 3 provides the ADPLL circuit of example 2, further including a delay flip flop (DFF) connected to receive the signal $P_0$ and output a signal $P_1$, in which the signal $P_1$ controls operation of the second switch.

Example 4 provides the ADPLL circuit of example 3, in which the DFF is clocked by the DCO_CLK signal.

Example 5 provides the ADPLL circuit of example 3 or 4, in which a delay between the P0 signal and the P1 signal is equal to a period of the DCO_CLK signal.

Example 6 provides the ADPLL circuit of any one of examples 2-5, further including a reference divider for dividing a frequency of the REFCLK signal by a value REFDIV.

Example 7 provides the ADPLL circuit of example 6, in which the feedback divider control signal is generated by the digital filter in accordance with a feedback code (FB_CODE), in which the frequency of DCO_CLK signal is equal to the frequency of REFCLK divided by REFDIV multiplied by the FB_CODE.

Example 8 provides the ADPLL circuit of example 7, in which the FB_CODE includes an integer portion and a fractional portion.

Example 9 provides the ADPLL circuit of example 7 or 8, in which the digital filter includes a sigma-delta modulator for generating a FRAC_I_Z value from the FB_CODE.

Example 10 provides the ADPLL circuit of example 9, in which the phase difference is equal to a difference between a sum of the ADC0 and ADC1 signals and the FRAC_I_Z value.

Example 11 provides the ADPLL circuit of any one of examples 2-10, in which the feedback divider includes an integer divider.

Example 12 provides a circuit for synchronizing a phase of an output clock (DCO_CLK) signal output from a digitally controlled oscillator (DCO) with a phase of a reference clock (REFCLK) signal, the circuit including a first analog-to-digital converter (ADC) connected to receive a REF_P signal corresponding to the phase of the REFCLK signal via a first switch and output an ADC0 signal identifying a first point on a waveform corresponding to the REF_P signal; and a second ADC connected to receive the signal REF_P via a second switch and output an ADC1 signal identifying a second point on the waveform; in which a time between the first and second points corresponds to a period of the DCO_CLK signal; and in which a phase difference between the phase of the DCO_CLK signal and the phase of the REFCLK signal corresponds to a difference between a sum of the ADC0 and ADC1 signals and a fractional value derived from preselected digital filter control signals.

Example 13 provides the circuit of example 12, further including a digital filter configured to process the ADC0 and ADC1 signals to determine the phase difference and to generate a DCO control signal to the DCO to control a frequency of operation of the DCO based on the phase difference.

Example 14 provides the circuit of example 13, in which the first switch is controlled by a signal P0 and the second switch is controlled by a signal P1 and in which a phase difference between the signals P0 and P1 is equal to a period of the DCO_CLK signal.

Example 15 provides the circuit of example 14, further including a feedback divider for generating the signal P0 from the DCO_CLK signal and a feedback divider control signal including a value indicative of an amount by which to divide the frequency of the DCO_CLK signal.

Example 16 provides the circuit of example 15, further including a delay flip flop (DFF) clocked by the DCO_CLK signal, the DFF receiving as input the P0 signal and configured to output the P1 signal.

Example 17 provides a method of synchronizing a phase of an output clock (DCO_CLK) signal output from a digitally controlled oscillator (DCO) with a phase of a reference clock (REFCLK) signal, the method including receiving at a first analog-to-digital converter (ADC) via a first switch a REF_P signal corresponding to the phase of the REFCLK signal via a first switch; outputting from the first ADC an ADC0 signal identifying a first point on a waveform corresponding to the REF_P signal; receiving at a second ADC via a second switch the signal REF_P via a second switch; and outputting from the second ADC an ADC1 signal identifying a second point on the waveform; in which a time between the first and second points corresponds to a period of the DCO_CLK signal; and in which a phase difference between the phase of the DCO_CLK signal and the phase of the REFCLK signal corresponds to a difference between a sum of the ADC0 and ADC1 signals and a fractional value derived from preselected digital filter control signals.

Example 18 provides the method of example 17, further including processing the ADC0 and ADC1 signals to determine the phase difference; and generating a DCO control signal to the DCO to control a frequency of operation of the DCO based on the phase difference.

Example 19 provides the method of example 18, further including generating a signal P0 from the DCO_CLK signal and a feedback divider control signal including a value indicative of an amount by which to divide the frequency of the DCO_CLK signal; and controlling operation of the first switch using the signal P0.

Example 20 provides the method of example 19, further including generating from the signal P0 a signal P1 for controlling operation of the second switch, in which a phase difference between the signals P0 and P1 is equal to a period of the DCO_CLK signal.

*Variations and other notes*

The detailed description, such as the "Select examples" section, provide various examples of the embodiments disclosed herein.

As used herein, the term "coupled to" or "coupled with" refers to a relationship between electronic components or circuit elements wherein the components are in electronic communication with one another and capable of transmitting and/or receiving electrical signals between them. The term "coupled to" does not require a direct physical or electrical connection between the coupled components. Rather, "coupled to" can encompass arrangements where the components are connected through one or more intervening elements, components, circuits, or transmission paths. For example, a first component may be "coupled to" a second component through intermediate components such as resistors, capacitors, inductors, transistors, logic gates, buses, transformers, or other electronic components, or through intermediate transmission paths, while still maintaining the capability for electronic communication between the first and second components.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

For purposes of explanation, specific numbers, materials and configurations are set forth in order to provide a thorough understanding of the illustrative implementations. However, it will be apparent to one skilled in the art that the present disclosure may be practiced without the specific details and/or that the present disclosure may be practiced with only some of the described aspects. In other instances, well known features are omitted or simplified in order not to obscure the illustrative implementations.

Further, references are made to the accompanying drawings that form a part hereof, and in which are shown, by way of illustration, embodiments that may be practiced. It is to be understood that other embodiments may be utilized, and structural or logical changes may be made without departing from the scope of the present disclosure. Therefore, the following detailed description is not to be taken in a limiting sense.

Various operations may be described as multiple discrete actions or operations in turn, in a manner that is most helpful in understanding the disclosed subject matter. However, the order of description should not be construed as to imply that these operations are necessarily order dependent. In particular, these operations may not be performed in the order of presentation. Operations described may be performed in a different order from the described embodiment. Various additional operations may be performed or described operations may be omitted in additional embodiments.

For the purposes of the present disclosure, the phrase "A or B" or the phrase "A and/or B" means (A), (B), or (A and B). For the purposes of the present disclosure, the phrase "A, B, or C" or the phrase "A, B, and/or C" means (A), (B), (C), (A and B), (A and C), (B and C), or (A, B, and C). The term "between," when used with reference to measurement ranges, is inclusive of the ends of the measurement ranges.

The description uses the phrases "in an embodiment" or "in embodiments," which may each refer to one or more of the same or different embodiments. The terms "comprising," "including," "having," and the like, as used with respect to embodiments of the present disclosure, are synonymous. The disclosure may use perspective-based descriptions such as "above," "below," "top," "bottom," and "side" to explain various features of the drawings, but these terms are simply for ease of discussion, and do not imply a desired or required orientation. The accompanying drawings are not necessarily drawn to scale. Unless otherwise specified, the use of the ordinal adjectives "first," "second," and "third," etc., to describe a common object, merely indicates that different instances of like objects are being referred to and are not intended to imply that the objects so described must be in a given sequence, either temporally, spatially, in ranking or in any other manner.

In the following detailed description, various aspects of the illustrative implementations will be described using terms commonly employed by those skilled in the art to convey the substance of their work to others skilled in the art.

The terms "substantially," "close," "approximately," "near," and "about," generally refer to being within +/- 20% of a target value as described herein or as known in the art. Similarly, terms indicating orientation of various elements, e.g., "coplanar," "perpendicular," "orthogonal," "parallel," or any other angle between the elements, generally refer to being within +/- 5-20% of a target value as described herein or as known in the art.

In addition, the terms "comprise," "comprising," "include," "including," "have," "having" or any other variation thereof, are intended to cover a non-exclusive inclusion. For example, a method, process, or device, that comprises a list of elements is not necessarily limited to only those elements but may include other elements not expressly listed or inherent to such method, process, or device. Also, the term "or" refers to an inclusive "or" and not to an exclusive "or."

The systems, methods and devices of this disclosure each have several innovative aspects, no single one of which is solely responsible for all desirable attributes disclosed herein. Details of one or more implementations of the subject matter described in this specification are set forth in the description and the accompanying drawings.

The following is a list of further preferred embodiments of the invention:

Embodiment 1. An all-digital phase locked loop (ADPLL) circuit, comprising:
a phase comparator for comparing a phase of a reference clock (REFCLK) signal input to the ADPLL circuit with a phase of an output clock (DCO_CLK) signal output from a digitally controlled oscillator (DCO), the phase comparator comprising:

a first analog-to-digital converter (ADC) connected to receive a REF_P signal corresponding to the phase of the REFCLK signal via a first switch and output an ADC0 signal; and

a second ADC connected to receive the signal REF_P via a second switch and output an ADC1 signal;

a digital filter for receiving the ADC0 and ADC1 signals and determining therefrom a difference between the phase of the DCO_CLK signal and the phase of the REFCLK signal, the digital filter configured to provide a DCO control signal to the DCO to control a frequency of operation of the DCO based on the phase difference.

Embodiment 2. The ADPLL circuit of embodiment 1, further comprising a feedback divider configured to receive the DCO_CLK signal from the DCO, perform frequency division on the received DCO_CLK signal based on a feedback divider control signal, and output a signal P0 indicative of the phase of the divided DCO_CLK signal, wherein the signal P0 controls operation of the first switch.

Embodiment 3. The ADPLL circuit of embodiment 2, further comprising a delay flip flop (DFF) connected to receive the signal P0 and output a signal P1, wherein the signal P1 controls operation of the second switch.

Embodiment 4. The ADPLL circuit of embodiment 3, wherein the DFF is clocked by the DCO_CLK signal.

Embodiment 5. The ADPLL circuit of embodiment 3, wherein a delay between the P0 signal and the P1 signal is equal to a period of the DCO_CLK signal.

Embodiment 6. The ADPLL circuit of embodiment 2, further comprising a reference divider for dividing a frequency of the REFCLK signal by a value REFDIV.

Embodiment 7. The ADPLL circuit of embodiment 6, wherein the feedback divider control signal is generated by the digital filter in accordance with a feedback code (FB_CODE), wherein the frequency of DCO_CLK signal is equal to the frequency of REFCLK divided by REFDIV multiplied by the FB_CODE.

Embodiment 8. The ADPLL circuit of embodiment 7, wherein the FB_CODE comprises an integer portion and a fractional portion.

Embodiment 9. The ADPLL circuit of embodiment 7, wherein the digital filter comprises a sigma-delta modulator for generating a FRAC_I_Z value from the FB_CODE.

Embodiment 10. The ADPLL circuit of embodiment 9, wherein the phase difference is equal to a difference between a sum of the ADC0 and ADC1 signals and the FRAC_I_Z value.

Embodiment 11. The ADPLL circuit of embodiment 2, wherein the feedback divider comprises an integer divider.

Embodiment 12. A circuit for synchronizing a phase of an output clock (DCO_CLK) signal output from a digitally controlled oscillator (DCO) with a phase of a reference clock (REFCLK) signal, the circuit comprising:

a first analog-to-digital converter (ADC) connected to receive a REF_P signal corresponding to the phase of the REFCLK signal via a first switch and output an ADC0 signal identifying a first point on a waveform corresponding to the REF_P signal; and

a second ADC connected to receive the signal REF_P via a second switch and output an ADC1 signal identifying a second point on the waveform;

wherein a time between the first and second points corresponds to a period of the DCO_CLK signal; and

wherein a phase difference between the phase of the DCO_CLK signal and the phase of the REFCLK signal corresponds to a difference between a sum of the ADC0 and ADC1 signals and a fractional value derived from preselected digital filter control signals.

Embodiment 13. The circuit of embodiment 12, further comprising a digital filter configured to process the ADC0 and ADC1 signals to determine the phase difference and to generate a DCO control signal to the DCO to control a frequency of operation of the DCO based on the phase difference.

Embodiment 14. The circuit of embodiment 13, wherein the first switch is controlled by a signal P0 and the second switch is controlled by a signal P1 and wherein a phase difference between the signals P0 and P1 is equal to a period of the DCO_CLK signal.

Embodiment 15. The circuit of embodiment 14, further comprising a feedback divider for generating the signal P0 from the DCO_CLK signal and a feedback divider control signal comprising a value indicative of an amount by which to divide the frequency of the DCO_CLK signal.

Embodiment 16. The circuit of embodiment 15, further comprising a delay flip flop (DFF) clocked by the DCO_CLK signal, the DFF receiving as input the P0 signal and configured to output the P1 signal.

Embodiment 17. A method of synchronizing a phase of an output clock (DCO_CLK) signal output from a digitally controlled oscillator (DCO) with a phase of a reference clock (REFCLK) signal, the method comprising:

receiving at a first analog-to-digital converter (ADC) via a first switch a REF_P signal corresponding to the phase of the REFCLK signal via a first switch;

outputting from the first ADC an ADC0 signal identifying a first point on a waveform corresponding to the REF_P signal;

receiving at a second ADC via a second switch the signal REF_P via a second switch; and

outputting from the second ADC an ADC1 signal identifying a second point on the waveform;

wherein a time between the first and second points corresponds to a period of the DCO_CLK signal; and

wherein a phase difference between the phase of the DCO_CLK signal and the phase of the REFCLK signal corresponds to a difference between a sum of the ADC0 and ADC1 signals and a fractional value derived from preselected digital filter control signals.

Embodiment 18. The method of embodiment 17, further comprising:

processing the ADC0 and ADC1 signals to determine the phase difference; and
generating a DCO control signal to the DCO to control a frequency of operation of the DCO based on the phase difference.

Embodiment 19. The method of embodiment 18, further comprising:

generating a signal P0 from the DCO_CLK signal and a feedback divider control signal comprising a value indicative of an amount by which to divide the frequency of the DCO_CLK signal; and

controlling operation of the first switch using the signal P0.

Embodiment 20. The method of embodiment 19, further comprising:
generating from the signal P0 a signal P1 for controlling operation of the second switch, wherein a phase difference between the signals P0 and P1 is equal to a period of the DCO_CLK signal.

**Claims**

1. An all-digital phase locked loop (ADPLL) circuit, comprising:
a phase comparator for comparing a phase of a reference clock (REFCLK) signal input to the ADPLL circuit with a phase of an output clock (DCO_CLK) signal output from a digitally controlled oscillator (DCO), the phase comparator comprising:

a first analog-to-digital converter (ADC) connected to receive a REF_P signal corresponding to the phase of the REFCLK signal via a first switch and output an ADC0 signal; and
a second ADC connected to receive the signal REF_P via a second switch and output an ADC1 signal;
a digital filter for receiving the ADC0 and ADC1 signals and determining therefrom a difference between the phase of the DCO_CLK signal and the phase of the REFCLK signal, the digital filter configured to provide a DCO control signal to the DCO to control a frequency of operation of the DCO based on the phase difference.

2. The ADPLL circuit of claim 1, further comprising a feedback divider configured to receive the DCO_CLK signal from the DCO, perform frequency division on the received DCO_CLK signal based on a feedback divider control signal, and output a signal P0 indicative of the phase of the divided DCO_CLK signal, wherein the signal P0 controls operation of the first switch.

3. The ADPLL circuit of claim 2, further comprising a delay flip flop (DFF) connected to receive the signal P0 and output a signal P1, wherein the signal P1 controls operation of the second switch.

4. The ADPLL circuit of claim 3, wherein the DFF is clocked by the DCO_CLK signal.

5. The ADPLL circuit of claim 3, wherein a delay between the P0 signal and the P1 signal is equal to a period of the DCO_CLK signal.

6. The ADPLL circuit of claim 2, further comprising a reference divider for dividing a frequency of the REFCLK signal by a value REFDIV.

7. The ADPLL circuit of claim 6, wherein the feedback divider control signal is generated by the digital filter in accordance with a feedback code (FB_CODE), wherein the frequency of DCO_CLK signal is equal to the frequency of REFCLK divided by REFDIV multiplied by the FB_CODE.

8. The ADPLL circuit of claim 7, wherein the FB_CODE comprises an integer portion and a fractional portion.

9. The ADPLL circuit of claim 7, wherein the digital filter comprises a sigma-delta modulator for generating a FRAC_I_Z value from the FB_CODE, and/or wherein the phase difference is equal to a difference between a sum of the ADC0 and ADC1 signals and the FRAC_I_Z value.

10. The ADPLL circuit of claim 2, wherein the feedback divider comprises an integer divider.

11. A circuit for synchronizing a phase of an output clock (DCO_CLK) signal output from a digitally controlled oscillator (DCO) with a phase of a reference clock (REFCLK) signal, the circuit comprising:

a first analog-to-digital converter (ADC) connected to receive a REF_P signal corresponding to the phase of the REFCLK signal via a first switch and output an ADC0 signal identifying a first point on a waveform corresponding to the REF_P signal; and
a second ADC connected to receive the signal REF_P via a second switch and output an ADC1 signal identifying a second point on the waveform;
wherein a time between the first and second points corresponds to a period of the DCO_CLK signal; and
wherein a phase difference between the phase of the DCO_CLK signal and the phase of the REFCLK signal corresponds to a difference between a sum of the ADC0 and ADC1 signals and a fractional value derived from preselected digital filter control signals.

12. The circuit of claim 11, further comprising a digital filter configured to process the ADC0 and ADC1 signals to determine the phase difference and to generate a DCO control signal to the DCO to control a frequency of operation of the DCO based on the phase difference, and/or
wherein the first switch is controlled by a signal P0 and the second switch is controlled by a signal P1 and wherein a phase difference between the signals P0 and P1 is equal to a period of the DCO_CLK signal.

13. The circuit of claim 12, further comprising a feedback divider for generating the signal P0 from the DCO_CLK signal and a feedback divider control signal comprising a value indicative of an amount by which to divide the frequency of the DCO_CLK signal, and/or
further comprising a delay flip flop (DFF) clocked by the DCO_CLK signal, the DFF receiving as input the P0 signal and configured to output the P1 signal.

14. A method of synchronizing a phase of an output clock (DCO_CLK) signal output from a digitally controlled oscillator (DCO) with a phase of a reference clock (REFCLK) signal, the method comprising:

receiving at a first analog-to-digital converter (ADC) via a first switch a REF_P signal corresponding to the phase of the REFCLK signal via a first switch;
outputting from the first ADC an ADC0 signal identifying a first point on a waveform corresponding to the REF_P signal;

receiving at a second ADC via a second switch the signal REF_P via a second switch; and
outputting from the second ADC an ADC1 signal identifying a second point on the waveform;
wherein a time between the first and second points corresponds to a period of the DCO_CLK signal; and
wherein a phase difference between the phase of the DCO_CLK signal and the phase of the REFCLK signal corresponds to a difference between a sum of the ADC0 and ADC1 signals and a fractional value derived from preselected digital filter control signals.

15. The method of claim 14, further comprising:

processing the ADC0 and ADC1 signals to determine the phase difference; and
generating a DCO control signal to the DCO to control a frequency of operation of the DCO based on the phase difference, and/or
further comprising:

generating a signal P0 from the DCO_CLK signal and a feedback divider control signal comprising a value indicative of an amount by which to divide the frequency of the DCO_CLK signal; and
controlling operation of the first switch using the signal P0, and/or

further comprising:
generating from the signal P0 a signal P1 for controlling operation of the second switch, wherein a phase difference between the signals P0 and P1 is equal to a period of the DCO_CLK signal.

100

COMPUTING SYSTEM

102
PROCESSOR

104
INPUT / OUTPUT INTERFACES

106
COMMUNICATIONS

108
COMPUTER-READABLE STORAGE MEDIA

112
MEDIA DRIVE

120
MEDIA DISK ASSEMBLY

122
READ / WRITE HEADS

110
MEMORY

124
PREAMPLIFIER

126
CONTROLLER

**FIG. 1**

200

204
REFERENCE CLOCK SIGNAL

202
TDC

208
VCO

206
OUTPUT CLOCK SIGNAL

210
LOOP FILTER

**FIG. 2**

300

REFCLK → REF DIVIDER (306) → $P_R$ → TDC (302) → DIGITAL LOOP FILTER (312) → DCO (308)

$P_T$

DCO_CLK → FEEDBACK DIVIDER (309) → $P_F$ → DTC (304)

FBDIV<M:0>

SIGMA-DELTA MODULATOR (310)

FB_INTG<M:0>, FB_FRAC<N:0>

FRAC_I_Z<K:0>

**FIG. 3**

FIG. 4

**FIG. 5**

**FIG. 6**

EP 4 686 103 A1

**FIG. 7**

EP 4 686 103 A1

FIG. 8

**FIG. 9**

EP 4 686 103 A1

1000 ⟍

1002 ⟍
| INPUT REF_P TO A PAIR OF ADCS VIA RESPECTIVE SWITCHES |

1004 ⟍
| SAMPLE REF_P USING ADC0 AT TIME t=0 TO GENERATE ADC0<K:0> |

1006 ⟍
| SAMPLE REF_P USING ADC1 AT TIME t=0 + $T_{DCO}$ TO GENERATE ADC1<K:0> |

1008 ⟍
| INPUT ADC0<K:0> AND ADC1<K:0> TO DIGITAL FILTER MODULE |

1010 ⟍
| COMPARE SUM OF ADC0<K:0> AND ADC1<K:0> WITH CODE FRAC_I_Z <k:0> |

1012 ⟍
| PROCESS DIFFERENCE BETWEEN SUM OF ADC0<K:0> AND ADC1<K:0> AND CODE FRAC_I_Z <k:0> TO GENERATE DCO CONTROL SIGNAL |

1014 ⟍
| PROCESS FBCODE TO GENERATE INTEGER CONTROL SIGNAL FOR CONTROLLING OPERATION OF INTEGER FEEDBACK DIVIDER |

1016 ⟍
| DIVIDE FREQUENCY OF DCO_CLK IN ACCORDANCE WITH INTEGER CONTROL SIGNAL |

1018 ⟍
| GENERATE STROBE CLOCK FOR ADC SAMPLING |

**FIG. 10**

Europäisches
Patentamt

European
Patent Office

Office européen
des brevets

## EUROPEAN SEARCH REPORT

Application Number

EP 25 19 0473

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | SEOL JI-HWAN ET AL: "Reference Oversampling PLL Achieving -256-dB FoM and -78-dBc Reference Spur", IEEE JOURNAL OF SOLID-STATE CIRCUITS, IEEE, USA, vol. 56, no. 10, 25 June 2021 (2021-06-25) , pages 2993-3007, XP011879915, ISSN: 0018-9200, DOI: 10.1109/JSSC.2021.3089930 [retrieved on 2021-09-22] | 1-8, 10-15 | INV. H03L7/081 H03L7/091 |
| A | * sections II to IV; page 2994 - page 3003; figures 1-23 * | 9 | |
| A | XU ZULE ET AL: "A 2 GHz 3.1 mW type-I digital ring-based PLL", ESSCIRC CONFERENCE 2016: 42ND EUROPEAN SOLID-STATE CIRCUITS CONFERENCE, IEEE, 12 September 2016 (2016-09-12), pages 205-208, XP032980844, DOI: 10.1109/ESSCIRC.2016.7598278 [retrieved on 2016-10-18] * section II; page 205 - page 207; figures 1-6 * | 1-15 | |
| A | US 2017/353189 A1 (CHEN TSE-PENG [TW]) 7 December 2017 (2017-12-07) * paragraph [0024] - paragraph [0037]; figures 3-11 * | 1-15 | TECHNICAL FIELDS SEARCHED (IPC) H03L |
| A | US 2022/085822 A1 (KUNDU SOMNATH [US] ET AL) 17 March 2022 (2022-03-17) * paragraph [0012] - paragraph [0046]; figures 1-4 * | 1-15 | |

The present search report has been drawn up for all claims

| Place of search | Date of completion of the search | Examiner |
|---|---|---|
| The Hague | 15 December 2025 | Wienema, David |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

 

& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 25 19 0473

15-12-2025

| Patent document cited in search report | Publication date | Patent family member(s) | | Publication date |
|---|---|---|---|---|
| US 2017353189 A1 | 07-12-2017 | CN | 107465410 A | 12-12-2017 |
| | | EP | 3255453 A1 | 13-12-2017 |
| | | TW | 201743563 A | 16-12-2017 |
| | | TW | 201828604 A | 01-08-2018 |
| | | US | 2017353189 A1 | 07-12-2017 |
| | | US | 2019348987 A1 | 14-11-2019 |
| US 2022085822 A1 | 17-03-2022 | NONE | | |

EPO FORM P0459

**EP 4 686 103 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 63675918